# EUROPÄISCHE PATENTSCHRIFT

(11) **EP 0 648 405 B1**
(45) Veröffentlichungstag und Bekanntmachung des Hinweises auf die Patenterteilung: **18.09.1996**
(21) Anmeldenummer: 93912602.5
(22) Anmeldetag: 21.06.1993
(51) Int. Cl.: H05K 13/08

(54) **ANORDNUNG UND VERFAHREN ZUM FUNKTIONSABGLEICH VON SCHALTUNGSFLACHBAUGRUPPEN**
ARRANGEMENT AND PROCESS FOR THE FUNCTIONAL ALIGNMENT OF FLAT CIRCUIT UNITS
DISPOSITIF ET PROCEDE D'EGALISATION FONCTIONNELLE DE MODULES PLATS DE CIRCUITS

(30) Priorität: 30.06.1992 DE 4223880
(43) Veröffentlichungstag der Anmeldung: 19.04.1995
(73) Patentinhaber: SIEMENS AKTIENGESELLSCHAFT, 80333 München (DE)
(72) Erfinder: GUDDACK, Thorsten, D-45894 Gelsenkirchen (DE); KROESEN, Klaus, D-46397 Bocholt (DE)
(86) Internationale Anmeldenummer: DE9300534
(87) Internationale Veröffentlichungsnummer: WO9400972

(56) Entgegenhaltungen:
- EP-A- 0 355 377
- PATENT ABSTRACTS OF JAPAN vol. 015, no. 379 (E-1115)25. September 1991
- PATENT ABSTRACTS OF JAPAN vol. 011, no. 077 (E-487)7. M rz 1987
- PATENT ABSTRACTS OF JAPAN vol. 015, no. 046 (E-1029)4. Februar 1991

## Beschreibung

Die Erfindung betrifft eine Anordnung und Verfahren zum Funktionsabgleich von Schaltungsflachbaugruppen gemäß dem Oberbegriff des Patentanspruchs 1 und 7.

Bei der Fertigung von Schaltungsflachbaugruppen, z.B. gedruckte Schaltungsplatinen (PCB = Printed Circuit Bord), wird zunächst auf eine einfache Flachbaugruppe eine Leiterbahnstruktur erzeugt. In einem sich daran anschließenden Bestückungsprozeß werden an vorgegebenen Bestückungspunkten der Leiterbahnstruktur elektronische Bauelemente, wie z.B. Widerstände, Kondensatoren, integrierte Schaltungen etc., angeordnet.

Die so entstandene Schaltungsflachbaugruppe ist in einer Vielzahl von elektrischen Einrichtungen, wie z.B. Personal Computer, Fernsprechendgeräte, Bild- und/oder Tonempfängern etc., einsetzbar. Der Einsatz solcher Schaltungsflachbaugruppen in den entsprechenden elektrischen Einrichtungen richtet sich dabei ausschließlich nach der vorhandenen Schaltung, also der Leiterbahnstruktur und den elektronischen Bauelementen.

Bevor die Schaltungsflachbaugruppen in den entsprechenden Einrichtungen zum Einsatz kommen, werden sie noch einer Qualitätsprüfung unterzogen. Die Qualitätsprüfung erfolgt dabei, um eine möglichst einfache Handhabung zu gewährleisten, in einer ohne Unterbrechungen durchgehenden Prüflinie, einer sogenannten Inline-Prüflinie. Bei dieser Qualitatsprüfung werden die aus der Fertigungslinie kommenden Schaltungsflachbaugruppen mit den darauf angeordneten elektronischen Bauelementen z. B. stromkreisgetestet (In Circuit Test), funktionsgetestet und abgeglichen.

Aus der EP-A2-0 229 486 und der Druckschrift JP 3-219 688, Patents Abstract's of Japan, E-1147, 18. Dezember 1991, Vol. 15 / Nr. 502 ist jeweils eine automatische Abgleichvorrichtung für Schaltungsflachbaugruppen bekannt, bei der eine den Abgleich vornehmende Justiereinrichtung nach Maßgabe von mit Hilfe einer Kamera ermittelten Ortskoordinaten für diesen Abgleich positioniert wird.

Aus der EP-A1-0 355 377 ist ein Verfahren zur optischen Prüfung von Flachbaugruppen bekannt, bei dem mitteles 3D-Sensoren und durch Abtasten mit Hilfe eines Laser-Scanners dreidimensionale Oberflächenkoordinaten der Flachbaugruppe ermittelt werden.

Für den Funktionsabgleich der Schaltungsflachgruppen mit den elektronischen Bauelementen wird gemäß der Druckschrift "elektro-anzeiger, 45. Jahrgang, Nr. 5, 9. Mai 1992, Seiten 84 und 85" ein Desktop Laser Trimmer mit Galvanometer Optik verwendet. Dieses Laser-Trim-System weist für den Funktionsabgleich eine Positioniereinrichtung auf, die die elektronischen Bauelemente auf den Schaltungsflachbaugruppen zur Abtastung und Veränderung von bauelementespezifischen physikalischen Schaltungsfunktionsvariablen, wie z. B. den Widerstand, die Ladung etc., von Schaltungsfunktionen, wie z. B. die Spannung, den Strom, die Frequenz etc., in den emittierten Lichtstrahl des Lasers positioniert. Das Laser-Trim-System weist darüber hinaus noch eine Meß-/Auswerteeinrichtung auf, die Schaltungsfunktionswerte mißt, diese mit vorgegebenen Abgleichwerten vergleicht und zur Steuerung von zyklischen Abgleichprozeduren mit dem Laser sowie der Positioniereinrichtung verbunden ist. In jedem Zyklus der Abgleichprozedur werden die abgetasteten elektronischen Bauelemente zur Veränderung der bauelementespezifischen physikalischen Schaltungsfunktionsvariablen mit dem Laser bearbeitet und der sich aus der Änderung der Schaltungsfunktionsvariablen ergebende Schaltungsfunktionswert gemessen und mit dem Abgleichwert verglichen.

Aufgabe der Erfindung ist es, eine Anordnung und ein Verfahren zum Funktionsabgleich von Schaltungsflachbaugruppen aufzubauen bzw. anzugeben, bei der bzw. dem auf der Schaltungsflachbaugruppe angeordnete elektronische Bauelemente auf einfache Weise automatisch funktionsabgeglichen werden.

Diese Aufgabe wird zum einen ausgehend von der im Oberbegriff des Patentanspruches 1 definierten Anordnung durch die in dem kennzeichnenden Teil des Patentanspruches 1 angegebenen Merkmale und zum anderen ausgehend von dem im Oberbegriff des Patentanspruches 7 definierten Verfahren durch die in dem kennzeichnenden Teil des Patentanspruchs 7 angegebenen Merkmale gelöst.

Durch die erfindungsgemäße Lösung wird die Handhabung von Schaltungsflachbaugruppen beim Abgleich von Schaltungsfunktionen, wie z.B. Spannung, Strom, Frequenz etc., verbessert.

Die Abtast- und Bearbeitungseinrichtung sind dabei als Laser ausgebildet, mit dem für den Funktionsabgleich z.B. Widerstandswerte von Widerstanden durch optisches Schneiden veränderbar sind (irreversible Veränderungen von bauelementespezifischen Schaltungsvariablen).

Alternativ ist es auch möglich, mit Hilfe des Lasers die Ortskoordinaten von elektronischen Bauelementen der Schaltungsflachbaugruppen zu ermitteln und einer Bearbeitungs- und Justiereinrichtung zu übergeben. Mit dieser Übergabe der Ortskoordinaten an die Bearbeitungs- und Justiereinrichtung sind somit auch in bezug auf bauelementespezifische Schaltungsvariablen reversibel veränderbare Bauelemente der Schaltungsflachbaugruppe funktionsabgleichbar.

Die Bearbeitungs- und Justiereinrichtung ist dabei z.B. als Schraubendreher ausgebildet, mit dem für den Funktionsabgleich z.B. die Kapazität von Drehkondensatoren und der Widerstand von Potentiometer veränderbar sind (reversible Veränderung von bauelementespezifischen Schaltungsvariablen).

Vorteilhafte Weiterbildungen der Erfindungen sind in den Unteransprüchen angegeben.

Ein Ausführungsbeispiel der Erfindung ist in den Figuren 1 bis 3 erläutert. Es zeigen:
Figur 1 eine Prüfanordnung mit mehreren entlang eines Transportsystems angeordneten Prüfstationen,
Figur 2 ein Laser-Trim-System bzw. eine Abgleichstation zum Funktionsabgleich von Schaltungsflachbaugruppen,
Figur 3 ein Ablaufdiagramm für den Funktionsabgleich der Schaltungsflachbaugruppen.

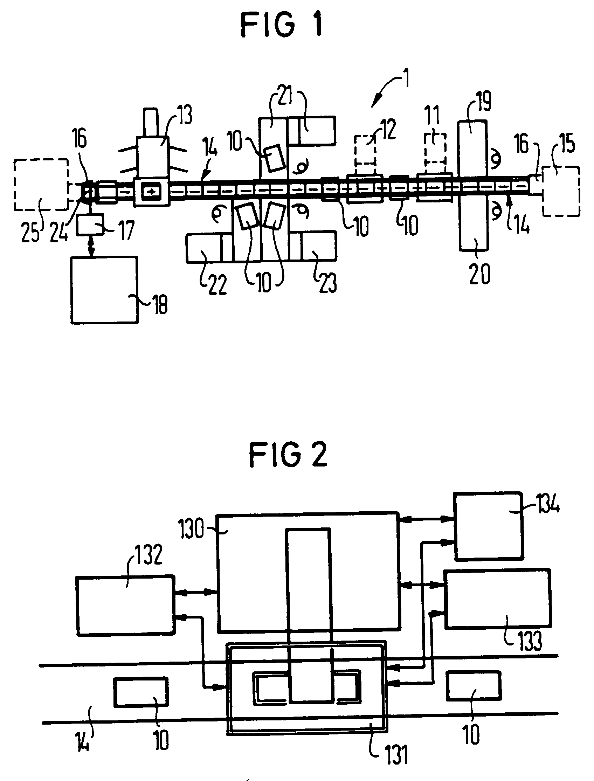

Figur 1 zeigt eine elektromechanische Prüfanordnung 1, mit der aus einer Fertigungslinie kommende Schaltungsflachbaugruppen 10 an verschiedenen Prüfstationen 11, 12, 13 entlang eines Transportbandes 14 im Rahmen einer Inline-Prüflinie funktionsüberprüfbar sind. Bei der dargestellten Prüfanordnung 1 werden die Schaltungsflachbaugruppen 10, wenn sie aus der Fertigungslinie kommen, zunächst in einem Magazin 15 abgelegt. Zum Weitertransport der in dem Magazin 15 abgelegten Schaltungsflachbaugruppen 10 ist das Magazin 15 mit dem Transportband 14 verbunden. Das zwischen zwei Umlenkrollen 16 umlaufende Transportband 14 wird von einer Antriebseinrichtung 17 angetrieben, die zur Steuerung der Bewegungsrichtung (vorwärts und rückwärts) des Transportbandes 14 mit einer Steuerung 18 gekoppelt ist. Wird das Transportband 14 durch die Antriebseinrichtung 17 und Steuerung 18 vorwärts (eingezeichnete Pfeile auf dem Transportband 14) bewegt, so werden die in dem Magazin 15 gelagerten Schaltungsflachbaugruppen 10 zunächst zu der Prüfstation 11 transportiert. Bei dieser Prüfstation 11 wird getestet, ob die auf der Schaltungsflachbaugruppe 10 angeordneten elektronischen Bauelemente kontaktiert bzw. angeschlossen sind (In Circuit Test). Stellt sich bei dieser ICT-Prüfung heraus, daß Fehler auf der Schaltungsflachbaugruppe 10 vorhanden sind, so wird die fehlerhafte Schaltungsflachbaugruppe 10 einem von zwei Fehlersuch-/Reparaturplätzen 19, 20 zugeführt. Verläuft die ICT-Prüfung jedoch fehlerfrei, so wird die Schaltungsflachbaugruppe 10 zur nächsten Prüfstation 12 weitertransportiert.

Bei der Prüfstation 12 handelt es sich um einen Prüfplatz, an dem die Schaltungsflachbaugruppen 10, bevor sie abschließend für den Funktionsabgleich zur Prüfstation 13 weitertransportiert werden, funktionsgetestet werden. Stellt sich bei diesem Funktionstest wie bei der ICT-Prüfung heraus, daß die Schaltungsflachbaugruppe 10 fehlerhaft ist, so wird diese fehlerhafte Schaltungsflachbaugruppe 10 entweder zu den Fehlersuch-/Reparaturplätzen 19, 20 oder zu weiteren Fehlersuch-/Reparaturplätzen 21, 22, 23 der Prüfanordnung 1 transportiert. Die genannten Fehlersuch-/Reparaturplätze 21, 22, 23 sind dabei auch für solche Schaltungsflachbaugruppen 10 vorgesehen, die in der Prüfstation 13 fehlerhaft funktionsabgeglichen sind.

Wie die Prüfstation 13, die wegen des vorzunehmenden Funktionsabgleichs im folgenden auch als Abgleichstation oder Laser-Trim-System bezeichnet wird, aufgebaut ist, ist in der Figur 2 dargestellt.

Schaltungsflachbaugruppen 10, die die Prüfstationen 11, 12, 13 der Prüfanordnung 1 ohne jegliche Mängel durchlaufen haben, werden von dem Transportband 14 zu einer Stempelstation 24 transportiert, bevor sie danach wiederum in einem weiteren Magazin 25 für weitere Bearbeitungsvorgänge, z. B. den Einbau in elektrische Einrichtungen (z. B. einem Fernsprechendgerät), zwischengelagert werden.

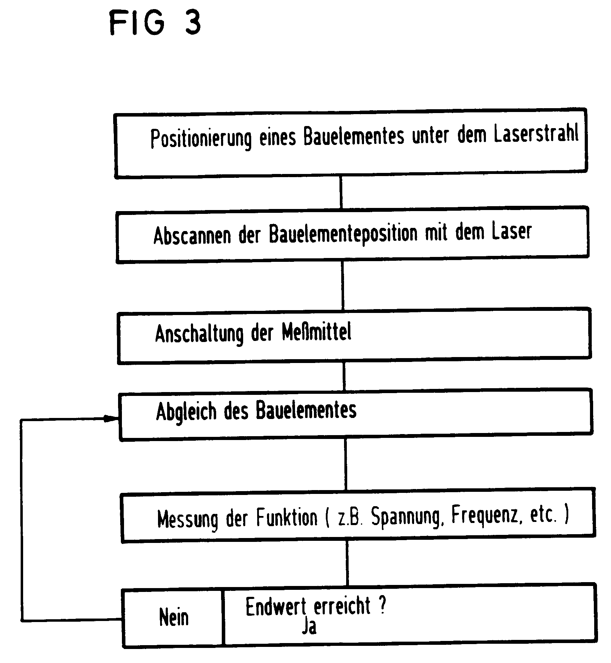

Figur 2 zeigt den Aufbau der Abgleichstation oder des Laser-Trim-Systems 13 für den Funktionsabgleich der auf dem Transportband 14 beförderten Schaltungsflachbaugruppen 10. Die Abgleichstation 13 weist dazu einen Laser 130 und eine Aufnahme 131 für die auf dem Transportband 14 beförderten Schaltungsflachbaugruppen 10 auf, die zur Steuerung des Ablaufes beim Funktionsabgleich der Schaltungsflachbaugruppen 10 gemäß Figur 3 mit einer Meß-/Auswerteeinrichtung 132, einer Steuereinrichtung 133 für die Aufnahme 131 und einer Justiereinrichtung 134 verbunden sind.

Der Ablauf beim Funktionsabgleich der Schaltungsflachbaugruppen 10 beginnt gemäß Figur 3 damit, daß jedes elektronische Bauelement der in der Aufnahme 131 befindlichen Schaltungsflachbaugruppe 10 unter dem von dem Laser 130 emittierten Lichtstrahl vorpositioniert wird. Die Vorpositionierung erfolgt dabei mit Hilfe eines der Aufnahme 131 zugeordneten X-Y-Tisches, auf den die mit dem Transportband 14 beförderten Schaltungsflachbaugruppen 10 abgelegt werden Der X-Y-Tisch wird dabei von der Steuereinrichtung 133 anhand von vorgegebenen Positionsdaten gesteuert. Nachdem das elektronische Bauelement durch den X-Y-Tisch und die Steuereinrichtung 133 unter den Lichtstrahl des Lasers 130 vorpositoniert worden ist, wird die exakte Postion (Ortskoordinaten) des elektronischen Bauelementes von dem Laser 130 abgetastet. Nach dieser Abtastung der Bauelementeposition wird das abgetastete elektronische Bauelement mit der Meß-/Auswerteeinrichtung 132 verbunden. Die Verbindung wird dadurch hergestellt, daß ein Kontaktiermodul, das ständig mit der Meß-/Auswerteeinrichtung 132 verbunden ist, von der Unterseite (Lötseite) der Schaltungsflachbaugruppe 10 mit dem elektronischen Bauelement kontaktiert wird. Mit der Anschaltung der Meß-/Auswerteeinrichtung 132 an das abgetastete elektronische Bauelement kann nunmehr der Funktionsabgleich des Bauelementes erfolgen. Dies geschieht durch eine zyklische Abgleichprozedur, bei der bis zur Identität von einem gemessenen Schaltungsfunktionswert und einem vorgegebenen Abgleichwert das elektronische Bauelement funktionsabgeglichen wird. In jedem Zyklus der Abgleichprozedur wird dabei das abgetastete Bauelement zur Veränderung bauelementespezifischer Schaltungsvariablen, wie z. B. Widerstand, Ladung, etc., von Schaltungsfunktionen, wie z. B. Spannung, Strom, Frequenz etc., bearbeitet und der sich aus der Änderung der Schaltungsvariablen ergebende Schaltungsfunktionswert gemessen und mit dem Abgleichwert verglichen. Die Bearbeitung des Bauelementes zur Veränderung der bauelementespezifischen Schaltungsvariablen kann sowohl unmittelbar mit dem Laser 130 als auch mittelbar über die Justiereinrichtung 134 erfolgen. Die mittelbare Bearbeitung der elektronnischen Bauelemente bietet sich inbesondere dann an, wenn es sich bei dem elektronischen Bauelement um ein reversibel einstellbares Bauelement, wie z. B. einen Drehkondensator oder ein Potentiometer, handelt. bei dieser mittelbaren Bearbeitung der reversibel einstellbaren Bauelemente werden durch Laserstrahlabtastung von dem Laser 130 ermittelte Ortskoordinaten des Drehkondensators, Potentiometers an die Justiereinrichtung 134 übergeben, die anhand dieser Koordinaten das Bauelement zur Veränderung der bauelementespezifischen Schaltungsvariablen entsprechend automatisch einstellt.

Für die Einstellprozeduren am Drehkondensator, Potentiometer ist die Justiereinrichtung 134 z. B. als Schraubendreher ausgebildet. Die Justiereinrichtng 134 kann aber auch für andere reversibel einstellbare elektronische Bauelemente multifunktional ausgebildet sein.

## Patentansprüche

1. Anordnung zum Funktionsabgleich von Schaltungsflachbaugruppen, mit einer Positioniereinrichtung (131, 133), die anhand von vorgegebenen Positionsdaten elektronischer Bauelemente der in einer Aufnahme (131) angeordneten Schaltungsflachbaugruppe (10) die Bauelemente für eine Abtastung vorpositioniert,
mit einer Abtasteinrichtung (130), die durch Abtasten Ortskoordinaten der elektronischen Bauelemente ermittelt,
mit einer Meß-/Auswerteeinrichtung (132), die Schaltungsfunktionsmessungen der in der Aufnahme (131) angeordneten Schaltungsflachbaugruppe (10) durchführt und
mit einer Bearbeitungseinrichtung (130, 134), die in Abhängigkeit von den Schaltungsfunktionsmessungen die elektronischen Bauelemente zur Veränderung bauelementespezifischer Schaltungsvariablen der Schaltungsfunktionen bearbeitet, **dadurch gekennzeichnet,** daß ein einziger Laser vorgesehen ist, der sowohl die Abtastung als auch die Bearbeitung der elektronischen Bauelemente übernimmt.

2. Anordnung mit dem Oberbegriff nach Anspruch 1,
**dadurch gekennzeichnet,** daß
a) die Abtasteinrichtung (130) als Laser ausgebildet ist, der die Ortskoordinaten von weiteren, in bezug auf die bauelementespezifischen Schaltungsvariablen reversibel veränderbaren elektronischen Bauelemente ermittelt und
b) eine Justiereinrichtung (134) vorgesehen ist, die mit Hilfe dieser ermittelten Ortskoordinaten durch Einstellprozeduren an den Bauelementen die bauelementespezifischen Schaltungsvariablen verändert.

3. Anordnung nach Anspruch 2, **dadurch gekennzeichnet,** daß die in bezug auf die bauelementespezifischen Schaltungsvariablen reversibel veränderbaren elektronischen Bauelemente als Drehkondensatoren und/oder Potentiometer ausgebildet sind.

4. Anordnung nach Anspruch 3, **dadurch gekennzeichnet,** daß die Justiereinrichtung (134) als Schraubendreher ausgebildet ist.

5. Anordnung nach einem der Ansprüche 1 bis 4, **dadurch gekennzeichnet,** daß die Schaltungsflachbaugruppen (10) Hochfrequenzschaltungen für Fernsprechendgeräte enthalten.

6. Verfahren zum Funktionsabgleich von Schaltungsflachbaugruppen, bei dem elektronische Bauelemente der Schaltungsflachbaugruppe (10) für eine Abtastung vorpositioniert werden,
bei dem durch Abtasten Ortskoordinaten der elektronischen Bauelemente ermittelt werden,
bei dem Schaltungsfunktionsmessungen an der Schaltungsflachbaugruppe (10) durchgeführt werden und
bei dem in Abhängigkeit von den Schaltungsfunktionsmessungen die elektronischen Bauelemente zur Veränderung bauelementespezifischer Schaltungsvariablen der Schaltungsfunktionen bearbeitet werden,
**dadurch gekennzeichnet,** daß die Ermittlung der Ortskoordinaten der elektronischen Bauelemente und die Bearbeitung der elektronischen Bauelemente zur Veränderung der bauelementespezifischen Schaltungsvariablen der Schaltungsfunktionen in Abhängigkeit von den Schaltungsfunktionsmessungen von einem einzigen Laser vorgenommen wird.

7. Verfahren nach dem Oberbegriff des Patentanspruches 6, **dadurch gekennzeichnet,** daß ein Laser die Ortskoordinaten von weiteren, in bezug auf die bauelementespezifischen Schaltungsvariablen reversibel veränderbaren elektronischen Bauelementen ermittelt und eine Justiereinrichtung (134) anhand der ermittelten Ortskoordinaten die bauelementespezifischen Schaltungsvariablen durch Einstellprozeduren an den Bauelementen verändert.

## Claims

1. Arrangement for the functional trimming of flat circuit units, having a positioning device (131, 133), which on the basis of predetermined position data of electronic components of the flat circuit unit (10) arranged in a receptacle (131) pre-positions the components for a scanning, having a scanning device (130), which determines local coordinates of the electronic components by scanning, having a measuring/evaluating device (132), which carries out circuit function measurements of the flat circuit unit (10) arranged in the receptacle (131) and having an operating device (130, 134), which in dependence on the circuit function measurements operates on the electronic components to alter component-specific circuit variables of the circuit functions, characterized in that a single laser is provided, which undertakes both the scanning and the operating on the electronic components.

2. Arrangement according to the precharacterizing clause of Claim 1, characterized in that
a) the scanning device (130) is designed as a laser which determines the local coordinates of further electronic components which can be reversibly altered in relation to the component-specific circuit variables and
b) an adjusting device (134) is provided, which with the aid of these determined local coordinates alters the component-specific circuit variables by setting procedures on the components.

3. Arrangement according to Claim 2, characterized in that the electronic components which can be reversibly altered in relation to the component-specific circuit variables are designed as variable capacitors and/or potentiometers.

4. Arrangement according to Claim 3, characterized in that the adjusting device (134) is designed as a screwdriver.

5. Arrangement according to one of Claims 1 to 4, characterized in that the flat circuit units (10) contain high-frequency circuits for telephone sets.

6. Process for the functional trimming of flat circuit units, in which electronic components of the flat circuit unit (10) are pre-positioned for a scanning, in which local coordinates of the electronic components are determined by scanning, in which circuit function measurements are carried out on the flat circuit unit (10) and in which, in dependence on the circuit function measurements, the electronic components are operated on to alter component-specific circuit variables of the circuit functions, characterized in that the determination of the local coordinates of the electronic components and the operating on the electronic components for altering the component-specific circuit variables of the circuit functions in dependence on the circuit function measurements are performed by a single laser.

7. Process according to the precharacterizing clause of Patent Claim 6, characterized in that a laser determines the local coordinates of further electronic components which can be reversibly altered in relation to the component-specific circuit variables and, on the basis of the local coordinates determined, an adjusting device (134) alters the component-specific circuit variables by setting procedures on the components.

## Revendications

1. Dispositif d'ajustement fonctionnel de modules plats de circuit, comportant un dispositif (131, 133) de positionnement, qui positionne au préalable, en référence à des données prescrites de position de composants électroniques du module (10) plat de circuit disposé dans un logement (131), les composants pour un balayage, un dispositif (130) de balayage qui détermine par balayage des coordonnées spatiales des composants électroniques,
un dispositif (132) de mesure/d'exploitation, qui effectue des mesures de fonction du circuit du module (10) plat disposé dans le logement (131) et
un dispositif (130, 134) de traitement, qui traite en fonction des mesures de fonction du circuit, les composants électroniques pour modifier des variables, spécifiques d'un composant, des fonctions du circuit, caractérisé en ce qu'il est prévu un laser unique, qui prend en charge à la fois le balayage et le traitement des composants électroniques.

2. Dispositif suivant le préambule de la revendication 1,
caractérisé en ce que
a) le dispositif (130) de balayage est sous forme d'un laser, qui détermine les coordonnées spatiales de composants électroniques supplémentaires, dont les variables de circuit spécifiques de composants peuvent être modifiées de manière réversible, et
b) il est prévu un dispositif (134) d'ajustement, qui modifie, à l'aide de ces coordonnées spatiales déterminées par des procédures de réglage des composants, les variables de circuit spécifiques de composants.

3. Dispositif suivant la revendication 2, caractérisé en ce que les composants électroniques dont les variables de circuit spécifiques de composants peuvent être modifiées de manière réversible, sont sous forme de condensateurs variables et/ou de potentiomètres.

4. Dispositif suivant la revendication 3, caractérisé en ce que le dispositif (134) d'ajustage est sous forme de tournevis.

5. Dispositif suivant l'une des revendications 1 à 4, caractérisé en ce que les modules (10) plats de circuit comprennent des circuits hautes fréquences pour des terminaux téléphoniques.

6. Procédé d'ajustement fonctionnel de modules plats de circuits, dans lequel on positionne au préalable des composants électroniques du module (10) plat de circuit pour un balayage,
dans lequel on détermine, par balayage, des coordonnées spatiales des composants électroniques,
dans lequel on effectue des mesures de fonction du circuit du module plat (10) et
dans lequel on traite, en fonction des mesures de fonction du circuit, les composants électroniques pour modifier des variables, spécifiques de composants, des fonctions du circuit,
caractérisé en ce que l'on procède, par un unique laser, à la détermination des coordonnées spatiales des composants électroniques et au traitement des composants électroniques pour modifier les variables, spécifiques de composants, des fonctions du circuit, en fonction des mesures de fonction du circuit.

7. Procédé suivant le préambule de la revendication 6,
caractérisé en ce qu'un laser détermine les coordonnées spatiales de composants électroniques supplémentaires, dont les variables de circuit spécifiques de composants peuvent être modifiées de manière réversible, et un dispositif (134) d'ajustement modifie, en référence aux coordonnées spatiales déterminées, les variables de circuit spécifiques de composants, par des procédures de réglage des composants.
